# EUROPÄISCHE PATENTSCHRIFT

(11) **EP 1 023 777 B1**
(45) Veröffentlichungstag und Bekanntmachung des Hinweises auf die Patenterteilung: **05.02.2003**
(21) Anmeldenummer: 98958174.9
(22) Anmeldetag: 29.09.1998
(51) Int. Cl.: H03M 7/30, H04B 1/66

(54) **VERFAHREN UND VORRICHTUNG ZUR ERZEUGUNG EINES BITRATENSKALIERBAREN AUDIO-DATENSTROMS**
METHOD AND DEVICE FOR LIMITING A STREAM OF AUDIO DATA WITH A SCALEABLE BIT RATE
PROCEDE ET DISPOSITIF POUR LIMITER UN COURANT DE DONNEES AUDIO DONT LE DEBIT BINAIRE PEUT ETRE MIS A L'ECHELLE

(30) Priorität: 02.10.1997 DE 19743662
(43) Veröffentlichungstag der Anmeldung: 02.08.2000
(73) Patentinhaber: SIEMENS AKTIENGESELLSCHAFT, 80333 München (DE)
(72) Erfinder: MUELLER, Joerg-Martin, D-71409 Schwaikheim (DE); WAECHTER, Bertram, D-71573 Allmersbach im Tal (DE)
(86) Internationale Anmeldenummer: DE9802877
(87) Internationale Veröffentlichungsnummer: WO99018673

(56) Entgegenhaltungen:
- WO-A-93/23956
- WO-A-97/15983
- US-A- 4 853 779
- BRANDENBURG K ET AL: "FIRST IDEAS ON SCALABLE AUDIO CODING" AMERICAN ENGINEERING SOCIETY CONVENTION, 10. November 1994, Seiten 1-6, A/B, XP000612978
- GRILL B ET AL: "A TWO- OR THREE-STAGE BIT RATE SCALABLE AUDIO CODING SYSTEM" AMERICAN ENGINEERING SOCIETY CONVENTION, 6. Oktober 1995, Seiten 1-8, XP000613371
- KUDUMAKIS P E ET AL: "WAVELET PACKET BASED SCALABLE AUDIO CODING" 1996 IEEE INTERNATIONAL SYMPOSIUM ON CIRCUITS AND SYSTEMS (ISCAS) CIRCUITS AND SYSTEMS CONNECTING THE WORLD, ATLANTA, MAY 12 - 15, 1996, Bd. 2, Mai 1996, Seiten 41-44, XP000613385 INSTITUTE OF ELECTRICAL AND ELECTRONICS ENGINEERS

## Beschreibung

### Stand der Technik

Die Erfindung betrifft ein Verfahren und eine Vorrichtung zur Erzeugung eines bitratenskalierbaren Audio-Datenstroms. Die Erfindung ist anwendbar auf dem Gebiet der Datenkommunikation, insbesondere auf dem Gebiet der Audio-Datenkommunikation.

Eine bekannte Problemstellung auf dem Gebiet der Datenkommunikation ist, dass das zu übertragende Datensignal in einer Datenquelle mit einer hohen Datenrate zur Verfügung steht, bspw. mit 64 kbit je Sekunde, aber der für eine Übertragung oder Verarbeitung zur Verfügung stehende Datenkanal die übertragenden Daten nur mit einer geringeren Datenrate übertragen kann, bspw. mit 32 kbit pro Sekunde. In diesem Fall müssen die Daten zunächst mit der hohen Datenrate dekodiert werden und anschließend mit der geringeren Datenrate neu kodiert werden. Dies bedingt einem hohen apparatetechnischen und rechentechnischen Aufwand, insbesondere da in modernen Datennetzen die Datenrate nicht konstant ist, sondern variabel ist und an den jeweiligen Belastungsfall des Datennetzes angepasst wird. Günstiger wäre demgegenüber die Bereitstellung eines bitratenskalierbaren Datentstroms, von dem nur ein Teil der zur Verfügung stehenden Datenbits übertragen werden, jeweils entsprechend der Datenrate, die der Übertragungskanal zur Verfügung stellt. Entsprechende Verfahren zur Erzeugung bitratenskalierbarer Audio-Datenströme werden derzeit weltweit insbesondere im Rahmen von Standardisierungsbemühungen unternommen, bspw. im Rahmen der MPEG 4 (Moving Picture Expert Group) - Standardisierung. Insbesondere müssen die im Rahmen der MPEG4-standardisierten entwickelten CODEC (COder/DECoder) die Funktionalität der Bitratenskalierbarkeit gewährleisten.

Aus der WO 97 159 83A ist ein Verfahren zur Erzeugung eines bitratenskalierbaren Audio-Datenstroms bekannt, bei dem der Audiodatenstrom in einem Core-Codec unter Ermittlung von Core-Parametern komprimiert wird. In nachgeschalteten Enhancement-Stufen wird die Codierung verbessert. Die Enhancement-Stufen werden in Abhängigkeit der Core-Parameter gesteuert.

Der Erfindung liegt daher das Problem zugrunde, ein Verfahren und eine Vorrichtung zur Erzeugung eines bitratenskalierbaren Audio-Datenstroms bereitzustellen, die vielseitig einsetzbarr sind, auch bei geringer zur Verfügung stehender Übertragungsrate eine gute Übertragungsqualität gewährleisten, und mit geringem Aufwand ein hohes Maß an Flexibilität hinsichtlich der Anpassung an die zur Verfügung stehende Übertragungs-Datenrate erzielen.

Das Problem wird durch die im Patentanspruch 1 offenbarten Merkmale gelöst. Besondere Ausführungsarten der Erfindung sind in den Unteransprüchen offenbart.

Das Problem ist bei einem Verfahren zur Erzeugung eines bitratenskalierbaren Audio-Datenstroms mit den Schritten Komprimieren des Audio-Eingangs-Datenstroms in einem Core-Codec unter Ermittlung von Core-Parametern, und Verbessern der Codierung in mindestens einer nachgeschalteten Enhancement-Stufe, dadurch gelöst, dass das Verbessern in der Enhancement-Stufe von den Core-Parametern gesteuert wird. Bei dem erfindungsgemäßen Verfahren bildet der Core-Codec die Kerneinheit und codiert den ankommenden Eingangs-Datenstrom mit einer niedrigen Bitrate von bspw. 2, 4 oder 6 kbit pro Sekunde. Der Core-Codec wird gefolgt von einer beliebigen Anzahl sogenannter Enhancement- oder Verbesserungs-Stufen, die je nach Anwendung mit einer

Datenrate von 1, 2, 3 oder 4 kbit pro Sekunde codieren. Ein Vorteil dieses Verfahrens ist, dass das Weglassen einer beliebigen Enhancement-Stufe keine Auswirkung auf die anderen Teile des Bit-Stroms hat. Eine wesentliche Bedingung ist, dass das zur Verfügung stehende Übertragungssystem zumindest die Bitrate des Core-Codec garantiert. Der Core-Codec parametrisiert das eingehende Audio-Signal und ermittelt bspw. Parameter wie Tonhöhe, stimmhafte/stimmlose Laute oder die Lautstärke. Eingesetzt werden kann bspw. ein Core-Codec gemäß ITU-T G.723.1 (ITU, International Telecommunication Union). Vorteilhaft ist bei dem erfindungsgemäßen Verfahren insbesondere, dass die von dem Core-Codec ermittelten Core-Parameter die nachgeschalteten Enhancement-Stufen steuern, weil dadurch eine erhebliche Erhöhung der Effizienz der Enhancement-Stufen erreicht wird.

In einer besonderen Ausführungsart der Erfindung ist das Verfahren dadurch gekennzeichnet, dass in der Enhancement-Stufe eine Vektorcodierung erfolgt und dass die Core-Parameter die Auswahl von Code-Büchern steuern. Dies ist vorteilhaft, da in periodischen Audio-Abschnitten andere Code-Bücher für die Vektorcodierung verwendet werden als in nichtperiodischen Audio-Abschnitten. Außerdem werden zur Codierung der Signalenergie (Lautstärke) die Energieparameter des Core-Codec direkt verwendet, was zu einer erheblichen Bitraten-Einsparung führt. Die Verwendung der Core-Parameter ist möglich, da diese in jedem Fall zum Empfänger werden.

Das Verfahren nach der Erfindung ist gekennzeichnet durch die Schritte Transformieren des Audio-Eingangs-Datenstroms, Transformieren eines von dem Core-Codec erstellten synthetisierten Audio-Signals, und Verknüpfen des transformierten synthetisierten Audio-Signals mit dem transformierten Audio-Datenstrom. Dadurch wird vorteilhaft mit geringem Aufwand und hoher Genauigkeit der Unterschied zwischen dem vom Core-Codec komprimierten Audio-Signal und dem Original-Signal ermittelt. Bei der Verknüpfung kann es sich im einfachsten Fall um eine Differenzbildung handeln; es können jedoch auch komplexere Operationen enthalten sein, wie bspw. eine Anpassung des Core-Spektrums zur besseren Adaption an das Original-Spektrum. In der letztgenannten besonderen Ausführungsart der Erfindung sind die der Anpassung dienenden Verknüpfungsparameter an den Empfänger zu übertragen.

In einer besonderen Ausführungsart der Erfindung ist das Verfahren dadurch gekennzeichnet, dass der Core-Codec das Eingangssignal in mindestens zwei Unterrahmen unterteilt, dass es sich bei dem Transformieren um eine Frequenztransformation handelt, die synchron zu den Unterrahmen des Core-Codec abläuft, dass durch die Frequenztransformation je Unterrahmen eine Transformation durchgeführt wird, die jeweils einen Spektrumsvektor hervorbringt, dass jeder Spektrumsvektor in mindestens zwei Teilvektoren entsprechend zwei Teilbändern unterteilt wird, und dass jede Enhancement-Stufe eines dieser Teilbänder verbessert. Die verwendete Frequenztransformation und die Unterteilung in Teilbänder bietet den Vorteil, dass das erfindungsgemäße Verfahren nicht nur nach objektiven Kriterien eine hohe Effizienz bei der Bitratenskalierung ermöglicht, sondern dass auch subjektive Kriterien, wie bspw. die akustisch-physiologischen Randbedingungen des menschlichen Gehörs, berücksichtigt werden. Welches Teilband verbessert wird, wird über eine Ressourcenzuteilungseinheit ermittelt. Diese Ermittlung kann wie bereits erwähnt über ein psychoakustisches Modell erfolgen, das feststellt, welche Frequenzbänder subjektiv wichtig sind, oder bspw. über Signal/Rausch-Abstandsmessungen erfolgen.

In einer besonderen Ausführungsart der Erfindung ist das Verfahren dadurch gekennzeichnet, dass je Verbesserungsstufe ein Parametersatz und eine Adresse des verbesserten Teilbandes übertragen wird. Da die Zuteilungseinheit die Teilbänder in der Reihenfolge ihrer Wichtigkeit verbessert, bietet diese Ausführungsart der Erfindung den Vorteil, dass die verbesserten Bits im Bitstrom in der Reihenfolge ihrer Wichtigkeit abgespeichert sind. Da jede Stufe mit einer Adresse versehen ist, kann dies im Empfänger problemlos und zuverlässig richtig zugeordnet werden. Eine Skalierung ist nun besonders problemlos und ohne jeden zusätzlich Aufwand lediglich durch Unterdrückung einer entsprechenden Anzahl von Verbesserungsstufen möglich, wobei mit der letzten, unwichtigsten Stufe begonnen wird. Weiterhin ist vorteilhaft, dass diese Skalierung an einem beliebigen Punkt der Übertragungsstrecke vorgenommen werden kann. Dabei ist eine zusätzliche Modifikation des verbleibenden Bitstroms nicht erforderlich.

In einer besonderen Ausführungsart der Erfindung ist das Verfahren gekennzeichnet durch Abspeichern, für jedes Teilband, wie viele Verbesserungsstufen für das jeweilige Teilband in einem zu übertragenden Bitstrom hintereinander vorhanden sind, Abspeichern von Zusatzinformationen für die Bestimmung der relativen Bedeutung der einzelnen Verbesserungsstufen der Teilbänder, und Zusammenführung des Bitstroms und der Zusatzinformation vor der Übertragung in einer Bitstrom-Manipulationseinheit. Dabei ist von Vorteil, dass gegenüber der vorgenannten Speicher- und Übertragungsformatierung ein geringerer Overhead durch die wegfallende Addressierung der einzelnen Verbesserungsstufen anfällt. Dieser Vorteil ist insbesondere für Datenbankzugriffe relevant.

In einer weiteren besonderen Ausführungsart der Erfindung ist das Verfahren gekennzeichnet durch ein Erzeugen von Teilbändern auf der Empfängerseite durch Berechnung aus empfangenen, benachbarten Teilbändern, insbesondere durch Interpolation. Für die Berechnung kommen neben der Interpolation auch weitere Verfahren der Mathematik in Betracht, bspw. Verfahren der Statistik unter Berücksichtigung der Charakteristiken des übertragenen Datenstroms. Vorteilhaft ist dabei, dass Teilbänder, die aufgrund einer Übertragungsstörung oder Übertragungsunterbrechung nicht oder nicht rechtzeitig beim Empfänger ankommen, rekonstruiert werden können, oder dass sogar Teilbänder vorausberechnet werden können, wenn einzelne Teilbänder oder Datenpakete auf dem Übertragungsweg verzögert werden.

Zu der Lehre der Erfindung gehört auch eine Vorrichtung zur Erzeugung eines bitratenskalierbaren Audio-Datenstroms mit einem Core-Codec, der den Audio-Eingangs-Datenstrom unter Ermittlung von Core-Parametern komprimiert, und mindestens einer, dem Core-Codec nachgeschalteten Enhancement-Stufe, dadurch gekennzeichnet, dass der Core-Codec mit der Enhancement-Stufe verbunden ist, und dass die Core-Parameter die Enhancement-Stufe steuern. Eine derartige Vorrichtung wird insbesondere dann von der Lehre der vorliegenden Erfindung erfasst, wenn sie eines der vorstehend beschriebenen Verfahren ausführt, insbesondere wenn sie ein Verfahren ausführt, bei dem die Vorrichtung eine Zuteilungssteuerung aufweist, die steuert, welches Teilband verbessert wird. Für die erfindungsgemäße Vorrichtung gelten die im Rahmen der Beschreibung des erfindungsgemäßen Verfahrens vorstehend genannten Vorteile entsprechend.

Von der Lehre der Erfindung wird auch erfasst die Verwendung von Core-Parametern eines Core-Codec zum Steuern der Verbesserung der Codierung in einer Enhancement-Stufe.

Vorteilhaft ist dabei insbesondere, dass die vom Core-Codec ermittelten und übertragenen Core-Parameter, die eine Parametrisierung des Eingangssignals repräsentieren, wirksam für die Steuerung der Verbesserungs-Stufen eingesetzt werden können und insbesondere die subjektive Übertragungsqualität schon ab einer ersten Verbesserungsstufe deutlich verbessern.

Von der Lehre der Erfindung wird auch erfasst ein Datenträger, auf dem Steuerinformationen gespeichert sind, dadurch gekennzeichnet, dass die Steuerinformationen den Ablauf eines der vorstehend beschriebenen Verfahren in einer elektronischen Rechenanlage oder in einer der vorstehend beschriebenen Vorrichtungen steuern. Der Datenträger kann dabei die Steuerinformation in beliebiger Form speichern, insbesondere in mechanischer, optischer, magnetischer oder elektronischer Form speichern. Vorteilhaft ist insbesondere, dass die so gespeicherten Steuerinformationen portabel, einfach zu implementieren, kostengünstig zu reproduzieren und mit geringem Aufwand zu warten sind. Eine Implementierung der Steuerinformation in einer elektronischen Rechenanlage ist mit Mitteln des Standes der Technik möglich.

Weitere Vorteile, Merkmale und Einzelheiten der Erfindung ergeben sich aus den Unteransprüchen sowie der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein. Ein Weg zum Ausführen der beanspruchten Erfindung ist nachfolgend anhand der Zeichnungen im Einzelnen erläutert.
- Figur 1: zeigt die erfindungsgemäße Vorrichtung mit einem Core-Codec und zwei Enhancement-Stufen.
- Figur 2: zeigt die Unterteilung eines Rahmens des Core-Codec in vier Unterrahmen.
- Figur 3: zeigt ein Speicher- und Übertragungsformat, das den subjektiven Prioritäten entspricht.
- Figur 4a: zeigt ein alternatives Speicher- und Übertragungsformat, das weniger Adressierungs-Overhead aufweist,
- Figur 4b: zeigt eine Bitmanipulations-Einheit entsprechend dem alternativen Speicher- und Übertragungsformat der Figur 4a.

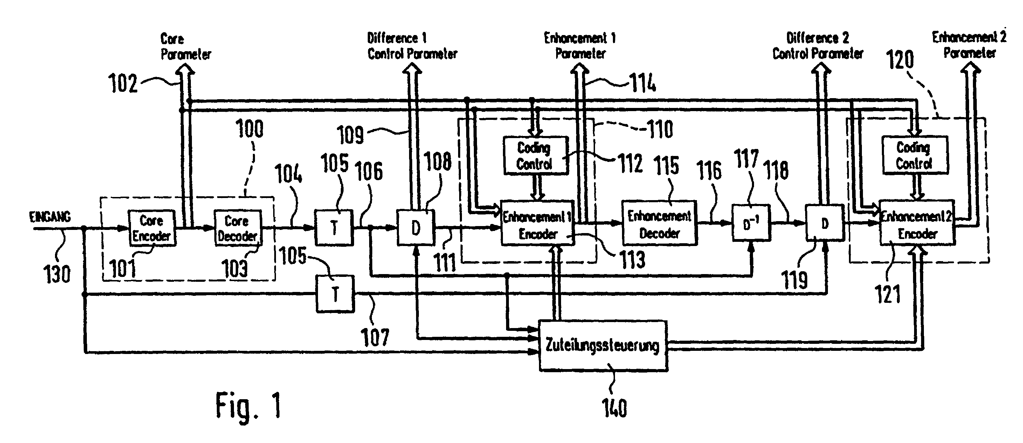

Die Figur 1 zeigt eine erfindungsgemäße Vorrichtung mit einem Core-Codec 100 und zwei Enhancement-Stufen 110, 120. Das Eingangssignal 130 wird zunächst mit dem Core-Encoder 101 komprimiert. Dieser Core-Encoder 101 kann einen beliebigen Algorithmus repräsentieren und kann mit einer beliebigen Abtastrate arbeiten. In einer bevorzugten Ausführungsform wird ein standardisierter Codec, bspw. ein Codec ITU-T, verwendet. Der vom Core-Encoder 101 erzeugte Bitstrom, die Core-Paramenter 102, wird abgespeichert. Anschließend erfolgt eine Decodierung mittels des Core-Decoder 103 unter Verwendung des Core-Algorithmus. Das vom Core-Decoder 103 erzeugte synthetisierte Audiosignal 104 wird, ebenso wie das ursprüngliche Eingangssignal 130, einer Rechenoperation 105 unterzogen. Diese Rechenoperation kann bspw. eine schnelle Fourier-Transformation (FFT) eine MDCT (Modified Discrete Cosine Transformation) oder eine QMF-Filterbank sein. Durch die Transformation 105 entsteht aus dem synthetisierten Audio-Signal 104 ein transformiertes, synthetisiertes Audio-Signal 106. Mittels der gleichen Transformation 105 entsteht aus dem Eingangssignal 130 ein transformiertes Eingangssignal 107. Das Eingangssignal 130, das transformierte Eingangssignal 107 und das transformierte, synthetisierte Audio-Signal 106 werden einer Zuteilungssteuerung 140 zugeführt. Außerdem werden die beiden Signale 106, 107 durch eine Operation 108 miteinander verknüpft. Im einfachsten Fall kann diese Operation 108 eine Differenzbildung (Subtraktion) sein, sie kann jedoch auch komplexere Operationen enthalten, bspw. eine Anpassung des Core-Spektrums zur besseren Adaption an das Original-Spektrum, wobei in diesem Fall die Anpassungsoder Kontroll-Parameter ebenfalls zu übertragen sind 109.

Das Verknüpfungssignal 111 wird anschließend einer ersten Verbesserungs- oder Enhancementstufe 110 zugeführt. Diese Verbesserungsstufe 110 kodiert nun das anstehende Signal 111. Als Codieralgorithmen sind verschiedene Verfahren der Audio-Codierung möglich, vorzugsweise wird eine Vektorquantisierung bzw. eine Vektorcodierung verwendet. Die Ergebnisse bzw. die Parameter 102 des Core-Codec 100 werden für die Steuerung und Konfiguration 112 dieses Codierabschnittes 113 der ersten Verbesserungsstufe 110 verwendet. Durch diese Maßnahme wird die Effizienz der Verbesserungsstufe 110 wesentlich verbessert. Die Verwendung der Core-Parameter 102 ist möglich, da diese auf jeden Fall zum Empfänger übertragen werden. Im dargestellten Fall steuern diese Core-Parameter 102 eine Codebuchauswahl. In periodischen Audio-Abschnitten werden andere Codebücher verwendet als in nichtperiodischen Audio-Abschnitten. Außerdem werden für die Codierung der Signalenergie (Lautstärke) die Energieparameter des Core-Codec 100 direkt verwendet, was zu einer Bitraten-Einsparung führt. Die Code-Bücher sind insbesondere trainiert und optimiert und werden ausgewählt, je nachdem in welchem Sprachabschnitt sich das Audio-Signal derzeit befindet, bspw. ob eine stimmhafte Lautfolge oder eine stimmlose Lautfolge vorliegt. Auf der Empfängerseite können die eingehenden empfangenen Daten interpretiert werden.

Die erste Verbesserungsstufe 110 erzeugt Enhancement 1 Parameter 114, die abgespeichert bzw. zum Empfänger übertragen werden. Durch eine Decodierung 115 entsteht wiederum ein decodiertes, verbessertes Signal 116. Das Signal 116 wird zusammen mit dem transformierten, synthetisierten Audio-Signal 106 einer inversen Differenzbildung 117 zugeführt. Das aus der inversen Differenzbildung 117 entstehende Signal 118 wird wiederum zusammen mit dem transformierten Eingangssignal 107 einer Verknüpfung 119 am Eingang einer zweiten Verbesserungsstufe 120 zugeführt. Es werden so viele Verbesserungsstufen 110, 120 angefügt, bis die auf dem Übertragungskanal zur Verfügung stehende Bitrate voll ausgeschöpft ist. Die Zuteilungssteuerung 140 steuert dabei die Codierstufen 113, 121 der Verbesserungsstufen 110, 120.

In dem vorgestellten Ausführungsbeispiel wird als Transformation 105 eine Frequenztransformation, insbesondere eine MDCT, durchgeführt. Diese Transformation läuft synchron zu den Unterrahmen (subframes) des Core-Codec 100, bei dem es sich um einen Core-Codec vom Typ ITU-T G.723.1 handelt. Dieser Core-Codec-Typ benutzt einen Rahmen von 30 Millisekunden Dauer, der in vier Unterrahmen mit jeweils 7,5 Millisekunden Dauer unterteilt ist.

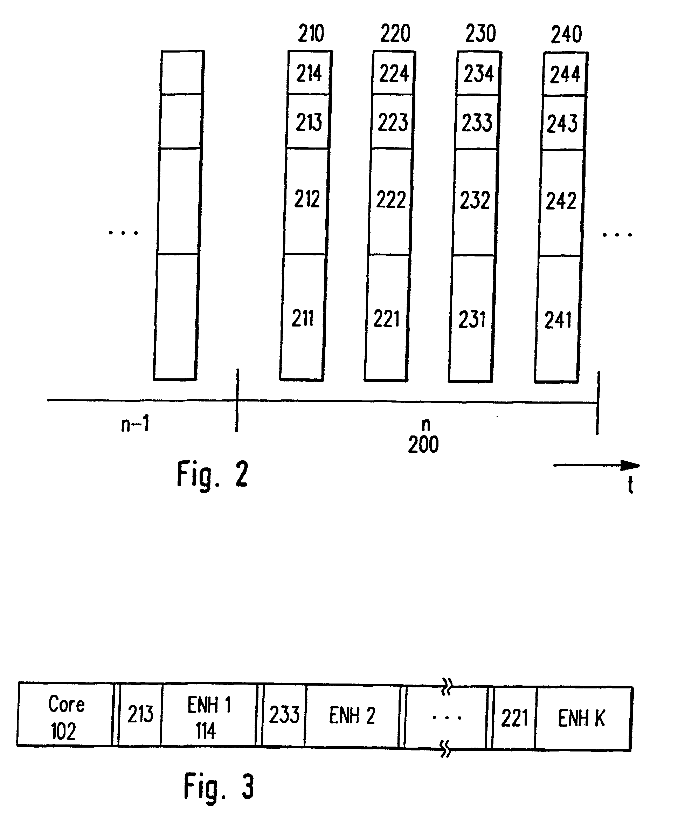

Die Figur 2 zeigt eine Unterteilung es Rahmens in vier Unterrahmen, wobei für jeden Rahmen ein Vektor mit Spektralwerten erzeugt wird, die nach subjektiven Kriterien in Bänder eingeteilt sind, bspw. durch eine Gruppierung nach BARKSCALE. Die Figur 2 zeigt entlang der horizontalen Zeitachse t einen Teil eines vorhergehenden Rahmens n-1 sowie einen kompletten Rahmen n 200. Pro Rahmen werden vier Transformationen durchgeführt und entsprechend vier Vektoren 210, 220, 230, 240 erzeugt. Jedem Spektrumsvektor entspricht im Zeitbereich ein Unterrahmen der Dauer 7,5 Millisekunden. Jeder Spektrumsvektor wird in vier Teilbänder unterteilt. Entsprechend weist der Spektrumsvektor 210 vier Teilbänder 211 bis 214 auf, der Spektrumsvektor 220 weist vier Teilbänder 221 bis 224 auf, der Spektrumsvektor 230 weist vier Teilbänder 231 bis 234 auf und der Spektrumsvektor 240 weist vier Teilbänder 241 bis 244 auf. Damit existieren pro Rahmen 200 insgesamt sechzehn Teilbänder. In jeder Verbesserungsstufe des Codieralgorithmus wird nun eines dieser sechszehn Teilbänder verbessert. Welches Teilband dabei verbessert wird, wird über die Zuteilungssteuerung 140 ermittelt und bestimmt. Diese Bestimmung kann auf der Grundlage eines psychoakustischen Modells erfolgen, das feststellt, welche Frequenzbänder subjektiv wichtig sind, oder über Signal/Rausch-Abstandsmessungen erfolgen. Die Verbesserungsstufe erzeugt einen Parametersatz, der abgespeichert wird. Zusätzlich zu diesen Parametern wird noch die Adresse des Bandes abgespeichert, welches verbessert wurde. Das verbesserte Teilband wird nun für die weitere Codierung berücksichtigt und der Verbesserungsvorgang erfolgt erneut. Dementsprechend kann davon ausgegangen werden, dass die Bits einer n-ten Verbesserungsstufe subjektiv wichtiger sind als die Bits einer (n+1)-ten Stufe. Es ist auch möglich, dass mehrere Verbesserungsstufen das gleiche Teilband verbessern.

Die Figur 3 zeigt die gespeicherte bzw. übertragene Bitfolge. Die Bitfolge beginnt mit den aus dem Core-Codec 100 ermittelten Core-Parametern 102. Darauf folgen nach einer Adresse 213 des verbesserten Teilbandes die Parameter der ersten Verbesserungsstufe ENH 1 114. Darauf folgt die Adresse 232 des zweiten verbesserten Teilbandes sowie die zugehörigen Enhancement-Parameter ENH 2. Das Ende des Bitstroms bildet die Adresse 222 des letzten verbesserten Teilbandes sowie die zugehörigen Enhancement-Parameter ENHK. Durch die Anordnung der Bits im Bitstrom in der Reihenfolge Core, erste Verbesserungsstufe, zweite Verbesserungsstufe usw. bis zur letzten Verbesserungsstufe werden die Bits automatisch entsprechend ihrer subjektiven Wichtigkeit geordnet. Da jede Stufe mit einer Adresse 213, 232, 221 versehen ist, kann dies im Empfänger richtig zugeordnet- weden. Eine Skalierung auf die zur Verfügung stehende Bitrate ist nun problemlos und ohne Aufwand durch Unterdrückung der Verbesserungsstufen möglich, wobei mit der letzten, unwichtigsten Stufe ENH K begonnen wird. Diese Skalierung kann an einem beliebigen Punkt der Übertragungsstrecke vorgenommen werden.

Einzelne Teilbänder müssen auch nicht absolut codiert werden, sondern können durch Prädiktion oder Interpolation aus benachbarten Bändern in einfacher Weise berechnet oder approximiert werden. Damit ist es möglich, einige Teilbänder nicht, oder nur mittels einer weniger Interpolationsparameter zu übertragen, und sie im Empfänger aus den benachbarten Bändern zu erzeugen. Im dargestellten Beispiel ist es möglich, die Teilbänder 212 und 232 aus den benachbarten Teilbändern zu interpolieren. Die Interpolation kann dabei sowohl aus zeitlich benachbarten Teilbändern wie auch aus im spektralen Frequenzbereich benachbarten Teilbändern erfolgen. Die beschriebenen Verfahren sind auch dann anwendbar, wenn die Transformation weniger als vier mal pro Rahmen durchgeführt wird, bspw. nur einmal. Günstige Realisierungen ergeben sich immer dann, wenn im Verbesserungsteil die gleiche Anzahl von Unterrahmen verwendet wird wie im Core-Codec.

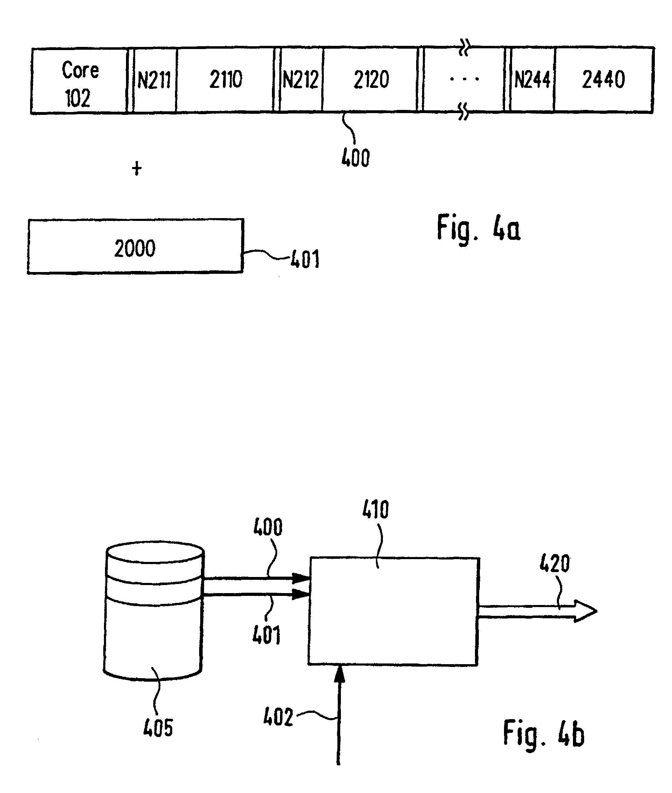

Die Figur 4a zeigt ein alternatives Speicher- und Übertragungsformat, welches weniger Adressierungs-Overhead aufweist. Ein solches Speicherformat ist insbesondere für Datenbankzugriffe geeignet. Für jedes Teilband 211, 212, 244 wird abgespeichert, wieviel Verbesserungsstufen N 211, N 212, N 244 dafür im Bitstrom vorhanden sind und alle Verbesserungsbits 2110, 2120, 2440 werden anschließend hintereinander abgespeichert. Damit geht die Organisation des Bitstroms nach der subjektiven Wichtigkeit verloren. Um bei der Skalierung jedoch zunächst die subjektivunwichtigsten Bits unterdrücken zu können, werden für jeden Audio-Datenrahmen zusätzliche Skalierungsinformationen 2000 abgespeichert, welche diese Information der subjektiven Wichtigkeit beinhalten.

Die Figur 4b zeigt eine Bitmanipulationseinheit entsprechend dem alternativen Speicher- und Übertragungsformat der Figur 4a. Die Bitmanipulationseinheit 410 erhält aus einer Audio-Datenbank 405 den Audio-Datenstrom 400 sowie die Skalierungsinformation 401. Entsprechend einer vorgegebenen Bitrate 402 werden nun in der Bitmanipulationseinheit 410 soviele Verbesserungsstufen unterdrückt, bis die zur Verfügung stehende Bitrate erreicht ist. Die Nebeninformationen im Bitstrom, insbesondere die Anzahl der Verbesserungsstufen je Teilband, muss natürlich nach dem Entfernen einer Stufe korrigiert werden. Der resultierende Datenstrom 420 wird anschließend übertragen.

Zwei wesentliche Anwendungsgebiete für die Bitratenskalierung sind nachfolgend beschrieben.

Bei einem Zugriff auf eine Audio-Datenbank, auf der eine Audioquelle mit maximaler Bitrate, bspw. mit 64 kbit pro Sekunde, encodiert und abgespeichert ist, kann mit unterschiedlichen Übertragungssystemen, die eine unterschiedliche Bitrate aufweisen, zugegriffen werden. Die Bitrate ist vor dem Versenden daher an die zur Verfügung stehende Bitrate des Übertragungssystems durch Unterdrückung geeigneter Bits oder durch Transcodierung anzupassen. Im Empfänger wird dabei eine für die skalierte Bitrate optimale Qualität garantiert.

Ein weiteres Beispiel ist die Übertragung in Übertragungssystemen mit variabler Bitrate, bspw. durch einen sogenannten ATM (Asynchronus Transfer Modus)-Modus oder bspw. im Internet. Bei einer derartigen Anwendung kann die Bitrate durch Unterdrückung geeigneter Bits in einem Vermittlungsknoten lokal angepasst werden, wenn dieser Vermittlungsknoten wegen Überlastung oder sonstiger Einflüsse den Audio-Datenstrom nicht mehr unverändert verarbeiten kann, um somit eine kontinuierliche Übertragung zu sichern.

## Patentansprüche

1. Ein Verfahren zur Erzeugung eines bitratenskalierbaren Audio-Datenstroms, aufweisend die Schritte:
Komprimieren des Audio-Datenstroms in einem Core-Codec (100) unter Ermittlung von Core-Parametern (102), und Verbessern der Codierung in mindestens einer nachgeschalteten Enhancement-Stufe (110), wobei das Verbessern in der Enhancement-Stufe (110) von den Core-Parametern (102) gesteuert wird, wobei der Audio-Datenstrom (130) frequenztransformiert (105) wird, wobei ein von dem Core-Codec (100) erstelltes synthetisiertes Audio-Signal (104) ebenfalls frequenztransformiert wird und wobei das frequenztransformierte synthetisierte Audio-Signal (106) mit dem frequenztransformierten Audio-Datenstrom (107) verknüpft (108) wird.

2. Verfahren nach Anspruch 1, **dadurch gekennzeichnet, dass** in der Enhancement-Stufe (102) eine Vektorcodierung erfolgt.

3. Verfahren nach Anspruch 1 oder 2, **dadurch gekennzeichnet, dass** die Core-Parameter (102) die Auswahl von Code-Büchern steuern.

4. Verfahren nach einem der Ansprüche 1 bis 3, **gekennzeichnet durch** das Übertragen der Verknüpfungsparameter an den Empfänger.

5. Verfahren nach Anspruch 1 oder 4, **dadurch gekennzeichnet, dass** der Core-Codec (100) das Eingangssignal (130) in mindestens zwei Unterrahmen unterteilt, und dass es sich bei dem Transformieren (105) um eine Frequenztransformation handelt, die synchron zu den Unterrahmen des Core-Codec (100) abläuft.

6. Verfahren nach Anspruch 5, **dadurch gekennzeichnet, dass** durch die Frequenztransformation (105) je Unterrahmen eine Transformation durchgeführt wird, die jeweils einen Spektrumsvektor (210, 220, 230, 240) hervorbringt, dass jeder Spektrumsvektor (210) in mindestens zwei Teilbänder (211 bis 214) unterteilt ist, und dass jede Enhancement-Stufe (110, 120) eines dieser Teilbänder (211 bis 214) verbessert.

7. Verfahren nach Anspruch 6, **dadurch gekennzeichnet, dass** je Enhancement-Stufe (110) ein Parametersatz (ENH1) und eine Adresse (213) des verbesserten Teilbandes übertragen wird.

8. Verfahren nach Anspruch 7, **gekennzeichnet durch** Abspeichern, für jedes Teilband, wieviele Enhancement-Stufen für das jeweilige Teilband in einem zu übertragenden Bitstrom hintereinander vorhanden sind (N211), Abspeichern von Zusatzinformationen (2000) für die Bestimmung der relativen Bedeutung der einzelnen Verbesserungsstufen der Teilbänder, und Zusammenführen des Bitstroms (400) und der Zusatzinformation (401) vor der Übertragung in einer Bitstrom-Manipulationseinheit (410).

9. Verfahren nach einem der Ansprüche 6 bis 8, **gekennzeichnet durch** Erzeugen von Teilbändern auf der Empfängerseite **durch** Berechnung aus empfangenen, benachbarten Teilbändern, insbesondere **durch** Interpolation.

10. Vorrichtung zum Durchführen des Verfahrens nach einem der Ansprüche 1 bis 9, **gekennzeichnet durch**:
- einen Core-Codec (100), der den Audio-Datenstrom (130) unter Ermittlung von Core-Parametern (102) komprimiert,
- mindestens einer, dem Core-Codec (100) nachgeschalteten Enhancement-Stufe (110), wobei der Core-Codec (100) mit der Enhancement-Stufe (110) verbunden ist,
- eine Wirkverbindung vom Core-Codec (100) zur Enhancement-Stufe (110), um **durch** die Core-Parameter (102) die Enhancement-Stufe (110) zu steuern,
- einer Frequenztransformationsstufe (105) für den Audio-Datenstrom (130),
- einer weiteren Frequenztransformationsstufe (105) für das vom Core-Codec 8100) erstellte synthetisierte Audio-Signal (104),
- einer Verknüpfungsstufe (8) für die der Frequenztransformation unterzogenen Signale.

11. Vorrichtung nach Anspruch 10, **dadurch gekennzeichnet, dass** die Vorrichtung eine Zuteilungssteuerung (140) aufweist, die steuert, welches Teilband verbessert wird.

## Claims

1. Method for producing an audio data stream with a scalable bit rate, having the following steps:
the audio data stream is compressed in a core codec (100) and core parameters (102) are ascertained, and the coding is improved in at least one downstream enhancement stage (110), where the improvement in the enhancement stage (110) is controlled by the core parameters (102), where the audio data stream (130) is subjected to frequency transformation (105), where a synthesized audio signal (104) produced by the core codec (100) is likewise subjected to frequency transformation, and where the frequency-transformed synthesized audio signal (106) is logically combined (108) with the frequency-transformed audio data stream (107).

2. Method according to Claim 1, **characterized in that** vector coding is performed in the enhancement stage (102).

3. Method according to Claim 1 or 2, **characterized in that** the core parameters (102) control the selection of code books.

4. Method according to one of Claims 1 to 3, **characterized by** transmission of the logical combination parameters to the receiver.

5. Method according to Claim 1 or 4, **characterized in that** the core codec (100) divides the input signal (130) into at least two subframes, and **in that** the transformation (105) is a frequency transformation which is executed in sync with the subframes from the core codec (100).

6. Method according to Claim 5, **characterized in that**, for each subframe, the frequency transformation (105) performs a transformation which respectively produces a spectrum vector (210, 220, 230, 240), **in that** each spectrum vector (210) is divided into at least two subbands (211 to 214), and **in that** each enhancement stage (110, 120) improves one of these subbands (211 to 214).

7. Method according to Claim 6, **characterized in that**, for each enhancement stage (110), a parameter set (ENH1) and an address (213) for the improved subband are transmitted.

8. Method according to Claim 7, **characterized by** storage, for each subband, of how many enhancement stages are available in succession for the respective subband in a bit stream which is to be transmitted (N211), storage of additional information (2000) for determining the relative significance of the subbands' individual improvement stages, and combination of the bit stream (400) and the additional information (401) before transmission in a bit stream manipulation unit (410).

9. Method according to one of Claims 6 to 8, **characterized by** generation of subbands at the receiver end by means of calculation from received, adjacent subbands, particularly by means of interpolation.

10. Apparatus for carrying out the method according to one of Claims 1 to 9, **characterized by**:
- a core codec (100) which compresses the audio data stream (130) and ascertains core parameters (102),
- at least one enhancement stage (110) connected downstream of the core codec (100), the core codec (100) being connected to the enhancement stage (110),
- an operative connection between the core codec (100) and the enhancement stage (110) for the purpose of using the core parameters (102) to control the enhancement stage (110),
- a frequency transformation stage (105) for the audio data stream (130),
- a further frequency transformation stage (105) for the synthesized audio signal (104) produced by the core codec (100),
- a combinational logic stage (8) for the signals which are subjected to frequency transformation.

11. Apparatus according to Claim 10, **characterized in that** the apparatus has an allocation controller (140) which controls which subband is improved.

## Revendications

1. Procédé pour générer un flot de données audio dont le débit binaire peut être mis à l'échelle, comprenant les étapes :
compression du flot de données audio dans un Core-Codec (100) par calcul de paramètres Core(102) et amélioration du codage dans au moins une étape d'optimisation (110) intercalée en aval, l'amélioration dans l'étape d'optimisation (110) étant commandée par les paramètres Core(102), le flot de données audio (130) étant transformé en fréquence (105), un signal audio synthétisé (104) établi par le Core-Codec (100) étant également transformé en fréquence et le signal audio synthétisé transformé en fréquence (106) étant combiné (108) avec le flot de données audio transformé en fréquence (107).

2. Procédé selon la revendication 1, **caractérisé en ce qu'**un codage vectoriel est effectué dans l'étape d'optimisation (102).

3. Procédé selon la revendication 1 ou 2, **caractérisé en ce que** les paramètres Core(102) commandent la sélection de livres de codes.

4. Procédé selon l'une des revendications 1 à 3, **caractérisé par** la transmission des paramètres combinatoires au récepteur.

5. Procédé selon la revendication 1 ou 4, **caractérisé en ce que** le Core-Codec (100) subdivise le signal d'entrée (130) en au moins deux sous-trames et **en ce que** la transformation (105) est une transformation de fréquence qui se déroule de façon synchrone avec les sous-trames du Core-Codec (100).

6. Procédé selon la revendication 5, **caractérisé en ce que** grâce à la transformation de fréquence (105, une transformation par sous-trame est effectuée, laquelle génère à chaque fois un vecteur spectral (210, 220, 230, 240), **en ce que** chaque vecteur spectral (210) est subdivisé en au moins deux sous-bandes (211 à 214) et **en ce que** chaque étape d'optimisation (110, 120) améliore une de ces sous-bandes (211 à 214).

7. Procédé selon la revendication 6, **caractérisé en ce que** par étape d'optimisation (110), un jeu de paramètres (ENH1) et une adresse (213) de la sous-bande améliorée sont transmis

8. Procédé selon la revendication 7, **caractérisé par** l'enregistrement, pour chaque sous-bande, combien d'étapes d'optimisation existent d'affilée pour la sous-bande respective dans un flot binaire à transmettre (N211), l'enregistrement d'informations supplémentaires (2000) permettant de déterminer l'importance relative des différentes étapes d'optimisation des sous-bandes et fusion du flot binaire (400) et de l'information supplémentaire (401) avant la transmission dans une unité de manipulation de flot binaire (410).

9. Procédé selon l'une des revendications 6 à 8, **caractérisé par** la génération de sous-bandes du côté du récepteur, par calcul à partir de sous-bandes voisines reçues, en particulier par interpolation.

10. Dispositif pour la mise en oeuvre du procédé selon l'une des revendications 1 à 9, **caractérisé par** :
- un Core-Codec (100) qui comprime le flot de données audio (130) par calcul de paramètres Core(102),
- au moins une étape d'optimisation (110) intercalée en aval du Core-Codec (100), le Core-Codec (100) étant couplé avec l'étape d'optimisation (110),
- une liaison active entre le Core-Codec (100) et l'étape d'optimisation (110), de manière à commander l'étape d'optimisation (110) par les paramètres Core(102),
- une étape de transformation de fréquence (105) pour le flot de données audio (130),
- une autre étape de transformation de fréquence (105) pour le signal audio synthétisé (104) établi par le Core-Codec (100),
- une étape combinatoire (8) pour les signaux soumis à la transformation de fréquence.

11. Dispositif selon la revendication 10, **caractérisé en ce que** ledit dispositif comprend une commande d'affectation (140) qui commande quelle sous-bande sera améliorée.
